# EUROPEAN PATENT SPECIFICATION

(11) **EP 0 284 439 B1**
(45) Date of publication and mention of the grant of the patent: **03.02.1993**
(21) Application number: 88302741.9
(22) Date of filing: 28.03.1988
(51) Int. Cl.: H01F 7/02

(54) **Magnetic field generating device**
Ein Magnetfeld erzeugende Vorrichtung
Dispositif pour la génération d'un champ magnétique

(30) Priority: 27.03.1987 JP 75689/87
(43) Date of publication of application: 28.09.1988
(73) Proprietor: SUMITOMO SPECIAL METALS CO. LTD., Osaka City Osaka (JP)
(72) Inventor: Miyamoto, Toshinobu Yamazaki Seisakusho, Shimamoto-cho Mishima-gun Osaka (JP); Sakurai, Hideya Yamazaki Seisakusho, Shimamoto-cho Mishima-gun Osaka (JP); Takabayashi,Hirofumi Yamazaki Seisakusho, Shimamoto-cho Mishima-gun Osaka (JP)
(74) Representative: Livsey, Gilbert Charlesworth Norris

(56) References cited:
- EP-A- 0 161 782
- FR-A- 985 815
- GB-A- 558 709
- GB-A- 923 537
- GB-A- 2 034 122
- JP-A-61 203 605
- NL-C- 84 047
- US-A- 2 786 971
- US-A- 3 253 194
- US-A- 3 984 706

## Description

The present invention relates to a magnetic field generating device which is for use in a medical nuclear magnetic resonance computerized tomographic apparatus (hereinafter referred to as an NMR-CT) capable of producing the tomographic image of an object and thereby exhibiting the properties of a tissue and which employs permanent magnets. More particularly, the present invention pertains to a magnetic field generating device which enables the static magnetic field intensity within a gap to be effectively improved so as to reduce the size and weight of the device.

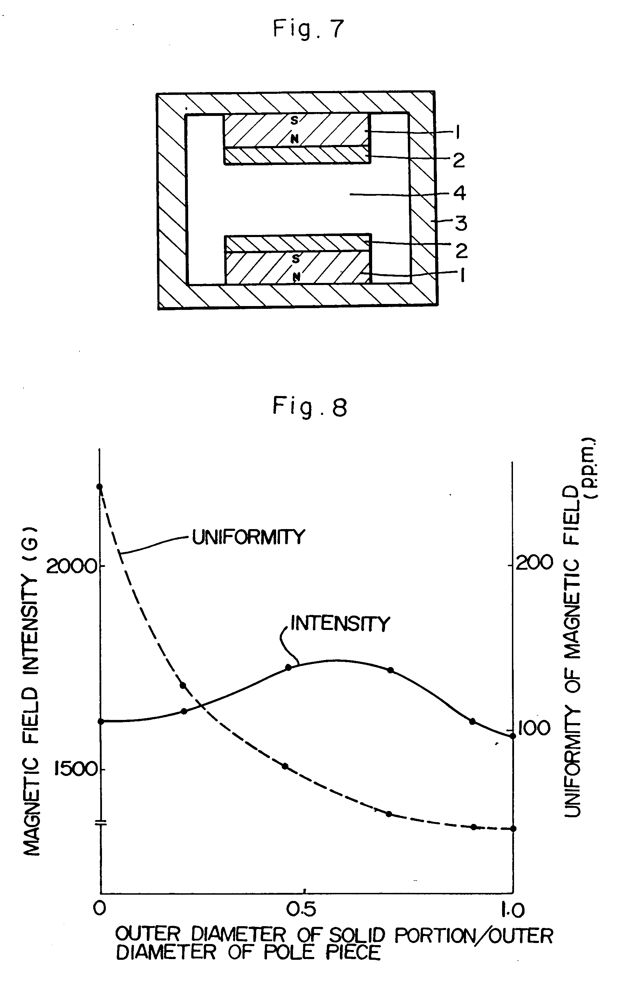

Figure 7 shows a known magnetic field generating device for use in the NMR-CT.

This magnetic field generating device includes a pair of permanent magnet components 1, pole pieces 2 which are each fixed to one end of each of the pair of permanent magnet components 1, and a yoke 3 coupling the other ends of the pair of permanent magnet components 1. A static magnetic field is generated within an air gap 4 formed between the pole pieces 2.

Magnetic field generating devices have been proposed US-A-4672346: EP-0 161 782 A1, which enable the degree of uniformity of the magnetic field generated in the gap 4 to be improved, one of the devices incorporating pole pieces 2 each of which has an annular protrusion at the outer periphery thereof, and the other incorporating pole pieces 2 each of which has a convex protrusion at the central portion.

In either of the above-described magnetic field generating devices, each pole piece 2 is in general a plate-like bulk formed by planing a magnetic material such as a carbon steel, i.e., the pole piece 2 has a solid structure.

Such pole piece 2 is effective in causing the magnetic flux generated by the permanent magnet component 1 to act uniformly within the gap 4. However, the permeability in the path of the magnetic flux within the pole piece 2 is equal in all directions, and part of the magnetic flux therefore leaks from the sides of the pole piece 2 into the surrounding yoke 3.

Therefore, in order to cause the magnetic flux generated by the permanent magnet component 1 to act effectively within the gap 4 so as to obtain a desired magnetic field intensity, the size of the permanent magnet component must be made large. This prevents a further reduction in the size of the NMR-CT.

Accordingly, and in particular for use in NMR-CT, there is provided according to this invention, the magnetic field generating device which is defined in claim 1. Further advantageous features of the invention are defined in the subsidiary claims.

One object of the present invention is to provide a magnetic field generating device which is capable of reducing the magnetic flux leaking from a pole piece, thereby causing the magnetic flux to become effectively concentrated in a gap so as to improve the magnetic field intensity, and which enables a reduction in the size and weight of the device and is easy to handle and maintain.

Another object of the present invention is to provide a magnetic field generating device which enables the degree of uniformity of the magnetic field, as well as the magnetic field intensity, to be improved.

Intensive studies have been made with the object of reducing the size and weight of a magnetic field generating device by reducing the magnetic flux leaking from its pole pieces and by causing the magnetic flux to be concentrated in the direction of the gap so as to improve the magnetic field intensity if the peripheral portion of each of the pole pieces is made of a laminate in which magnetic plates are laminated in the direction perpendicular to the side of the pole piece. The present invention is based on this conclusion.

More specifically, the present invention provides a magnetic field generating device including a pair of permanent magnet components disposed in such a manner as to face each other with a gap formed therebetween, a yoke magnetically coupling the pair of permanent magnet components, and pole-pieces which are fixed to a surface of a corresponding permanent magnet component that faces the gap, the magnetic field generating device being adapted to generate a magnetic field in the gap, which is characterised in that the peripheral portion of each of the pole-pieces is made of a laminate in which magnetic plates are laminated in the direction substantially perpendicular to the sides of the pole-pieces.

Since the peripheral portion of each of the pole pieces is a laminate of magnetic plates, substantially non-magnetic portions having a large magnetic reluctance are formed between the laminated magnetic plates. It is difficult for the magnetic flux generated by the permanent magnet components to pass through the non-magnetic portions which have a large magnetic reluctance, but it is easy for it to pass through the portions of the magnetic plates which have a small magnetic reluctance. In consequence, leakage of magnetic flux from the sides of each of the pole pieces can be reduced, thereby improving the magnetic field intensity within the gap. This ensures a structure having an excellent magnetic efficiency, and a magnetic field generating device which is small and light in weight.

In JP-A-61/203650, published in 1986, there has been proposed a disc-like or oval pole piece for generating a magnetic field of uniform intensity, the pole piece being formed of a coiled tape-like strip of soft magnetic material - see Figure 5 and claim 5 of that reference. The pole piece of this proposal has therefore, a uniform structure.

In contra-distinction, the pole piece now proposed has a non-uniform structure, with a central non-laminated solid core, surrounded by a laminate made up of magnetic and non-magnetic sheets. As will be apparent from the following description, such a structure provides a useful combination of, on the one hand, field intensity, and on the other hand, field uniformity.
Figure 1a is a schematic longitudinal sectional view of a magnetic field generating device of the present invention;
Figure 1b is a transverse sectional view of the magnetic field generating device of Figure 1a;
Figure 1c is an enlarged longitudinal sectional view showing a laminate of magnetic plates;
Figures 2 and 3 are longitudinal sectional views showing another pole piece structure of the magnetic field generating device of the present invention;
Figure 4 is a perspective view of an annular magnetic plate which forms part of the laminate;
Figure 5 is a longitudinal sectional view showing still another pole piece structure of the magnetic field generating device of the present invention;
Figure 6 is a longitudinal sectional view showing an example of application of the present invention as a magnetic field generating device for use in an NMR-CT;
Figure 7 is a longitudinal sectional view of a known magnetic field generating device;
Figure 8 is a graph showing the relationship between the dimension of a solid portion and the intensity and degree of uniformity of the magnetic field.

The magnetic circuit of the present invention may have any structure so long as it is constructed such that a pair of permanent magnet components are magnetically coupled by a yoke in such a manner that they face each other with a gap formed therebetween, and that a pole piece is fixed to a surface of a corresponding permanent magnet component that faces the gap. The structure of a laminate of magnetic plates as well as the position thereof are suitably selected in accordance with the magnetic characteristics and shape and dimension of the permanent magnet, the shape and dimensions of the yoke, or the size of the gap.

Permanent magnets that can be used for such a magnetic circuit include ferrite magnets, Alnico magnets, and rare earth cobalt magnets. However, use of an Fe-B-R permanent magnet, as has been proposed in Japanese published Patent specification No 145072/1982, is effective in reducing the size of the device. The Fe-B-R permanent magnet uses as R a light rare earth element which is an abundant natural resource such as Nd or Pr, and is mainly made of B and Fe. It exhibits an extremely high energy product of 238.8 KJ/m³ (30 MGOe) or more.

The pole pieces may have any known shape, such as disc-like with a rectangular shape in transverse cross-section. Or, in particular, each pole piece may have a trapezoidal form in transverse cross-section, in which the surface thereof which faces the gap is smaller than the surface thereof which abuts against the corresponding permanent magnet component so that the concentration of the magnetic flux within the gap is facilitated. Alternatively, it may have an annular protrusion around a peripheral portion of the surface thereof which faces the gap, and/or a convex protrusion at a central portion thereof.

The peripheral portion of each of the pole pieces should include a laminate of magnetic plates and non-magnetic sheets so disposed as to enable a reduction in the magnetic flux leakage from the sides of each pole piece.

The laminate may have any structure so long as it is formed of magnetic plates disposed in a direction substantially perpendicular to the sides of the pole piece and can have any of various forms. For example, a magnetic plate strip may be wound around the periphery of a disc-shaped pole piece so as to form the laminate. Alternatively, the laminate may be formed of a plurality of annular magnetic plates whose diameters are sequentially reduced by a value equivalent to the thickness of the plate, the annular magnetic plates being fitted into one another so as to form a laminate unit.

When a non-magnetic material such as a resin or paper is interposed between the magnetic sheets as they are laminated, the magnetic field intensity is further improved.

As only the peripheral portion of the pole piece is formed by the laminate of magnetic plates, it is not necessary to use the same material for the magnetic plates employed to form the laminate and for the solid unlaminated portion which constitutes the central portion of the pole piece. The material is suitably selected in accordance with the structure or shape thereof. For example, only the magnetic plates used for the laminate need be made of silicon steel sheet.

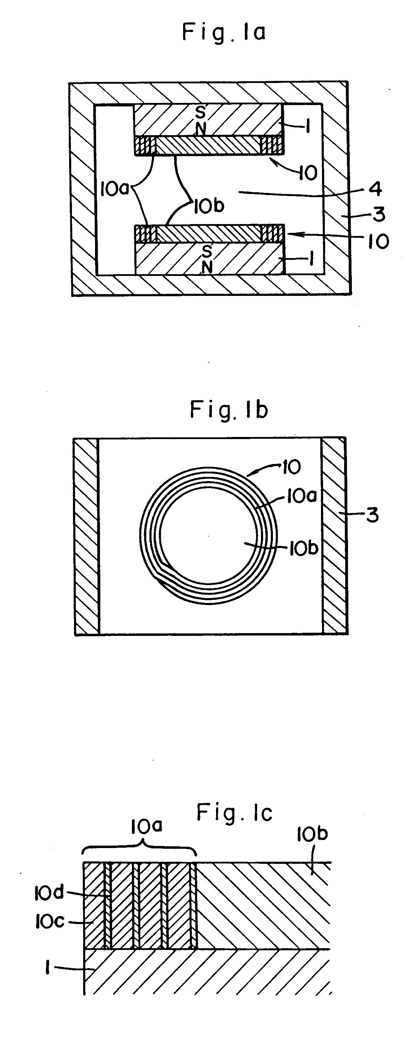

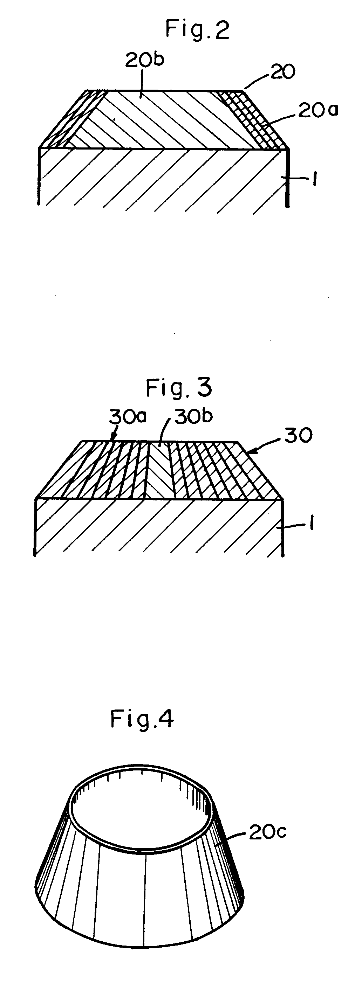

Figure 1 schematically shows a magnetic field generating device according to this invention, in which Figure 1a is a longitudinal sectional view thereof, Figure 1b is a transverse section thereof, and Figure 1c is a detailed longitudinal sectional view showing the laminate of magnetic plates. Figures 2,3 and 5 are longitudinal sectional views showing other examples of pole piece structure of the magnetic field generating device according to the present invention. Figure 4 is a perspective view of a single annular magnetic plate which constitutes part of the laminate.

As shown in Figure 1, the magnetic field generating device of the present invention includes a pair of permanent magnet components 1, pole pieces 10, each of which is fixed to one end of the permanent magnet components 1, and yoke for coupling the other ends of the permanent magnet components 1 in such a manner that a gap 4 is formed between the pole pieces 10. This structure serves to generate a static magnetic field within the gap.

Each of the pair of pole pieces 10 has a disc-like shape, and is comprised of a laminate 10a and a solid portion 10b, the laminate 10a forming a peripheral portion of the disc and the solid portion 10a constituting a core.

As shown in Figures 1b and 1c, the laminate 10a is formed in a direction perpendicular to the sides of the solid portion 10b of the pole piece by winding a magnetic plate strip 10c several times around the periphery of the disc-like solid portion 10b with a sheet of insulating paper 10d interposed between the magnetic layers of plate.

Because of the presence of the insulating paper 10d which has a large magnetic reluctance, the amount of the magnetic flux passing through each magnetic plate 10c of the laminate 10a decreases in the radial direction of the pole piece 10, i.e., in the lateral direction as viewed in Figure 1, and is directed into the gap 4, i.e., in the longitudinal or vertical direction as viewed in Figure 1.

Thus, with the pole piece 10 having this laminate 10a of the magnetic plates 10c around its peripheral portion, most of the magnetic flux generated by the permanent magnet component 1 does not leak from the sides of the pole piece, but is concentrated in the direction of the gap 4, thereby improving the magnetic field intensity within the gap 4.

In order to facilitate the concentration of the generated magnetic flux within the gap, pole pieces 20 and 30 shown in Figures 2 and 3 have a trapezoidal shape when viewed in transverse cross-section, and a surface of each of them that faces the gap is made smaller than a surface thereof that abuts against a corresponding magnet component 1. In the pole piece 20 shown in Figure 2, only the peripheral portion of the pole piece 20 is made of a laminate 20a, whereas a laminate 30a forms the greater part of the pole piece 30 shown in Figure 3.

The laminate 20a shown in Figure 2 is easily formed by, for example, preparing a predetermined number of truncated conical annular magnetic plates 20c such as those shown in Figure 4 whose diameters are increased by a value equivalent to the thickness and by fitting them sequentially to the outer lateral periphery of a solid portion 20b.

The pole piece 30 shown in Figure 3, i.e., the laminate 30a formed at the outer lateral periphery of a solid portion 30b may be formed in the manner shown in Figure 2. However, the plurality of magnetic plates 20c used to form the laminate 30a are prepared such that the thickness of each of the magnetic plates 20c is decreased as it gets close to the head portion thereof at the surface of the pole piece 2 which faces the gap 4, and that the angle of the laminating surface of the magnetic plate 20c which is located at the innermost side of the laminate is the closest to perpendicular. In this way, the concentration of the magnetic flux within the gap is further improved.

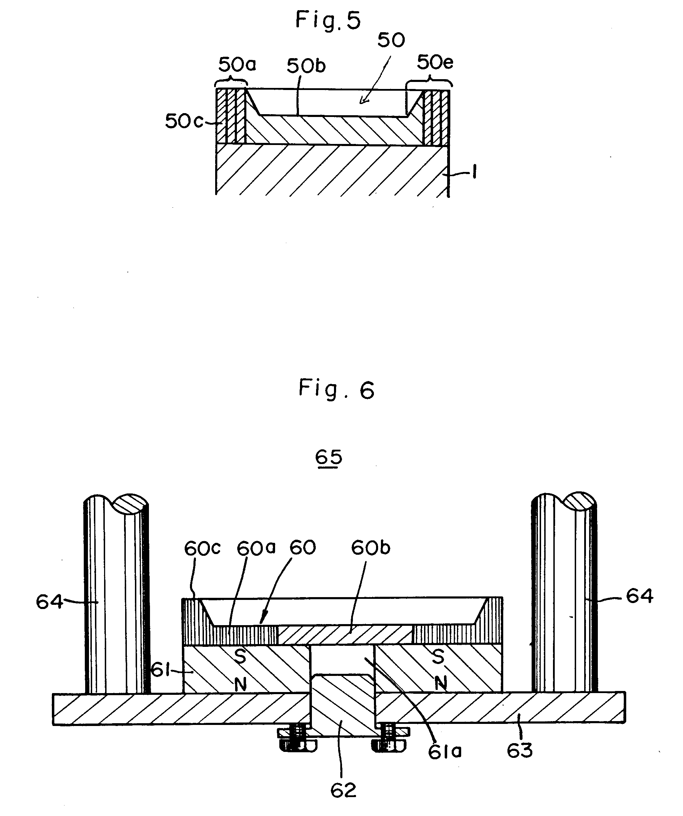

Figure 5 shows still another example of the structure of the pole piece. In a pole piece 50, the periphery of a surface of a solid portion 50b that faces the gap 4 is provided with an annular protrusion 50e having a trapezoidal cross section and whose inner diameter is inclined in such a manner that it expands upward. A laminate 50a of magnetic plates 50c is formed by wrapping the plates successively one on another in a direction perpendicular to the sides of the solid portion 50b containing the inclined portion of the annular protrusion 50e in such a manner that it forms part of the annular protrusion 50e.

Further, the central region of the solid portion 50b which is located inside the annular protrusion 50e may be provided with a protrusion having an oblate trapezoidal cross-section for the purpose of improving the degree of magnetic field uniformity within the gap.

If any of the pole pieces 20 30 and 50 shown in Figures 2, 3, and 5 is used, a greater part of the magnetic flux generated by each of the permanent magnet components 1 is concentrated in the direction of the gap without leaking from the sides of each of the pole pieces, thereby improving the magnetic field intensity within the gap 4.

Figure 6 shows an example of an application of the present invention as a magnetic field generating device for use in an NMR-CT.

Disc-shaped pole pieces 60 of the device are each comprised of a laminate 60a constituting the main feature of the present invention and a solid portion 60b. Each of the pole pieces 60 has an annular protrusion 60c at the peripheral portion thereof. Permanent magnet components 61 each have a through hole 61a at a central portion. A magnetic field fine adjustment slug 62 of magnetic material is inserted into the through-hole 61a, in such a manner that the amount of insertion of the slug 62 is adjustable, so as to enable fine adjustment of the magnetic field intensity within the gap 65 to be achieved. This magnetic field generating device also includes plate-like yokes 63 (only the lower plate-like yoke being shown in the drawing), and column-like yokes 64 for disposing the pair of plate-like yokes 63 with a gap having a predetermined size formed therebetween.

With the device thus arranged, the intensity and the degree of uniformity of the magnetic field within the gap 65 can be improved by suitably selecting the outer diameter of the solid portion 60b (the inner diameter of the laminate 60a), the height of the annular protrusion 60c, the diameter of the through-hole 60a formed in the permanent magnet component, and the amount of insertion of the magnetic field fine adjustment slug 62 of magnetic material. The intensity and the degree of uniformity of the magnetic field can further be improved to be superior to the prior art devices by selecting the ratio between the outer diameter of the solid portion 60b and the outer diameter of the entire-pole piece 60, the ratio of which being preferably in a range of 0.2:1 to 0.95:1.

### Example 1

A magnetic field generating device was constructed in the same manner as the magnetic field generating device shown in Figure 1 by employing Fe-B-R permanent magnets having a (BH) maximum of 278.6 KJ/m³ (35 MGOe), and pole pieces shown in Figure 5, each of the pole pieces being comprised of a solid portion 50b with an annular protrusion 50e formed at the peripheral portion thereof and a laminate 50a of magnetic plates provided around the outer periphery of the annular protrusion. In this device, each of the pole pieces 50 had a diameter of 850 mm, the solid portion 50b of each of the pole pieces had a diameter of 600 mm, and the distance between the opposed pair of pole pieces defining the gap 4 was set to 450 mm. The magnetic field intensity at the central portion of the gap 4 of this device was measured.

The laminate forming the peripheral portion 50a of each of the pole pieces 50 is formed of a magnetic plates made of a silicon steel sheet alternating with sheets of insulating paper. When the rate of occupation of the magnetic plates in the laminate was 90%, a magnetic field intensity of 0.1616 Teslar (1616 G) was measured. With a rate of occupation of magnetic plate of 70%, the magnetic field intensity was at 0.1734 Teslar (1734 G). Even with a rate of occupation of magnetic plate of about 30%, the magnetic field intensity was at more than 0.1600 Teslar (1600 G).

When the magnetic field intensity at the central portion of the gap 4 was measured, for comparison, in a magnetic field generating device as shown in Figure 7, constructed under the same conditions with the exception that each of the pole pieces 2 was made of a solid (i.e. un-laminated) pure iron, it was 0.1587 Teslar (1587 G).

The weight of the permanent magnet required to generate the same magnetic field intensity as measured was examined on the basis of the results of the measurement. For the magnetic field generating device of the comparison example, it became clear that 8 tons of permanent magnet would be necessary, whereas in a case of the magnetic field generating device according to the present invention, it was found that the weight could be reduced by 15% to 20%.

### Example 2

In a magnetic field generating device constructed in the same manner as that shown in Figure 6 and employing the Fe-B-R permanent magnets having a (BH) maximum of 278.6 KJ/m³ (35 MGOe), variations in the intensity and degree of uniformity of the magnetic field within the gap were measured as the dimension of the outer diameter of the solid portion 60b, i.e., the dimension of the inner diameter of the laminate 60a (which is formed by laminating the magnetic plates made of silicon steel sheet and having a thickness of 0.35 mm) changed. Figure 8 shows the results of the measurement.

At this time, the outer diameter of each of the pole pieces 60 was constant at 1160 mm. The gap 4 between the opposed pair of pole pieces was set to 520 mm and a rate of occupation of the magnetic plate of the laminate (60a) was 70%.

For comparison, a magnetic field generating device, as shown in Figure 7, was assembled under the same conditions as those of this device, with the exception that each of the pole pieces was made of a solid pure iron, and the same measurement was conducted. The degree of uniformity represents the values measured in a spherical space having a radius of 150 mm, with the centre of the gap 4 being the centre of the space.

It can be seen from the graph of Figure 8 that the magnetic field intensity within the gap improves in the magnetic field generating device according to the present invention, when compared with a case where the pole pieces, which are each formed only of a solid non-laminated structure, are used. It is also clear that the same or a higher degree of uniformity of the magnetic field was ensured, when the ratio between, on the one hand, the outer diameter of the solid portion and on the other hand, the outer diameter of the entire pole piece, is between 0.2:1 and 0.95:1.

## Claims

1. A magnetic field generating device which includes a pair of permanent magnet components (1) disposed in such a manner as to face each other with a gap formed therebetween, a yoke (3) for magnetically coupling said pair of permanent magnet components, and pole-pieces (10) which are each fixed at one end surface to a surface of an associated permanent magnet component, the opposite end surface thereof facing said gap, said magnetic field generating device being adapted to generate a magnetic field in said gap,
characterised in that
each said pole piece (10) is composed of a solid core portion (10b) which has an outer side surface, and an outer portion formed of a laminate (10a) of magnetic sheets and non sheets positioned around said solid core portion said laminate sheets (10a) lying substantially parallel with the outer side surface of said solid core portion (10b) of each magnetic pole-piece (10);
and wherein for each pole piece (10), the ratio of the outer diameter D_{B} of said solid non-laminated portion (10b) to the outer diameter D_{P} of said pole piece (10), D_{B}:D_{P}, is between 0.2:1 and 0.95:1.

2. A magnetic field generating device according to claim 1, further characterized in that
each said pole piece (10) comprises a solid core portion (10b) of magnetic material having an outer side surface which is a body of revolution about the magnetic field axis which extends across the gap (4) between the opposed poles, said solid core portion being surrounded by a laminate (10a) formed by a plurality of layers, the layers being disposed, one surrounding another, around the said outer side surface of said solid, non-laminated core portion (10b), and with the successive layers (10c, 10d) of said laminate being alternately of magnetic material, and of material having larger magnetic reluctance.

3. A magnetic field generating device according to claim 2 wherein said layers which are of magnetic material are secured to intervening plies or layers which are of non-magnetic material.

4. A magnetic field generating device according to claim 3, wherein said intervening plies or layers are composed of a resin or of paper.

5. A magnetic field generating device according to any one of claims 1 to 4, wherein said pole piece has a disc-like shape.

6. A magnetic field generating device according to any one of claims 1 to 4, wherein said pole piece has a disc-like shape, and wherein the peripheral portion of a surface of said pole piece that faces said gap is provided with an annular protrusion.

7. A magnetic field generating device according to any one of claims 1 to 4, wherein said pole piece has a disc-like shape, and wherein the peripheral portion of a surface of said pole piece that faces said gap is provided with an annular protrusion, and the central portion thereof is provided with a convex protrusion.

8. A magnetic field generating device according to any one of claims 1 to 4, wherein each of said pole pieces has a trapezoidal shape in transverse cross-section, with a surface thereof that faces said gap being smaller than a surface on the opposite side thereof that abuts against a permanent magnet component of the device.

9. A magnetic field generating device according to any one of claims 1 to 7 wherein the magnetic portion of said laminate is formed by one or more portions of helically wound magnetic strip material.

10. A magnetic field generating device according to any one of claims 1 to 7 wherein the magnetic portion of said laminate is formed of silicon steel sheet.

11. A magnetic field generating device according to any one of claims 1 to 10, wherein each of said pair of pole pieces (60) is secured to a respective one (63) of a pair of opposed permanent magnet components,
there being yoke means (64) magnetically coupling said pair of components,
and wherein each of said permanent magnet components (63) is an annular body having a through hole (61a) at the centre thereof and extending towards the pole piece (60) secured to that component( (63), and including a slug (62) of magnetic material inserted in, and adjustable in said hole (61a), to obtain fine adjustment of the magnetic field intensity in the gap (65) which is formed between the opposed pole pieces (60) of the magnetic field generating device.

## Patentansprüche

1. Eine ein Magnetfeld erzeugende Vorrichtung, die ein Paar von Permanentmagnet-Komponenten (1) aufweist, welche in einer solchen Weise angeordnet sind, daß sie unter Bildung eines Spaltes zwischen sich einander gegenüberliegen, sowie ein Joch (3) zur magnetischen Koppelung des besagten Paares von Permanentmagnet-Komponenten und Polstücke (10), die jeweils mit einer Endfläche an der Endfläche einer ihnen zugeordneten Permanentmagnet-Komponente befestigt sind, wobei ihre entgegengesetzte Endfläche dem besagten Spalt zugekehrt ist und die besagte ein Magnetfeld erzeugende Vorrichtung zur Erzeugung eines Magnetfeldes im besagten Spalt geeignet ist, dadurch gekennzeichnet, daß jedes besagte Polstück (10) aus einem festen Kernteil (10b), das eine äußere Seitenfläche besitzt, und einem Außenteil zusammengesetzt ist, welches aus einer Schichtung (10a) aus magnetischen Schichten und nicht magnetischen Schichten gebildet ist, die um das besagte feste Kernteil herum angeordnet ist, wobei die Schichten der Schichtung (10a) im wesentlichen parallel zur äußeren Seitenfläche des besagten festen Kernteils (10b) jedes magnetischen Polstücks (10) angeordnet sind und für jedes Polstück (10) das Verhältnis D_{B} : D_{P} des äußeren Durchmessers D_{B} des besagten festen, nicht geschichteten Teils (10b) zum äußeren Durchmesser D_{P} des besagten Polstücks (10) zwischen 0,2:1 und 0,95:1 liegt.

2. Eine ein Magnetfeld erzeugende Vorrichtung nach Anspruch 1, weiterhin dadurch gekennzeichnet, daß jedes besagte Polstück (10) ein festes Kernteil (10b) aus magnetischem Material mit einer äußeren Seitenfläche besitzt, das ein Rotationskörper um die Magnetfeldachse ist, welche sich über den Spalt (4) zwischen den einander gegenüberliegenden Polen erstreckt, und das besagte feste Kernteil von einer Schichtung (10a) umgeben ist, die aus einer Vielzahl von Schichten gebildet ist, welche einander umgebend um die besagte äußere Seitenfläche des besagten festen nicht geschichteten Kernteils (10b) herum angeordnet sind, wobei die aufeinanderfolgenden Schichten (10c, 10b) der besagten Schichtung abwechselnd aus magnetischem Material und aus Material mit größerem magnetischem Widerstand bestehen.

3. Eine ein Magnetfeld erzeugende Vorrichtung nach Anspruch 2, bei welcher besagte Schichten aus magnetischem Material so befestigt sind, daß sie zwischen Lagen oder Schichten aus nicht magnetischem Material angeordnet sind.

4. Eine ein Magnetfeld erzeugende Vorrichtung nach Anspruch 3, bei welcher die besagten dazwischenliegenden Lagen oder Schichten aus einem Harz oder aus Papier bestehen.

5. Eine ein Magnetfeld erzeugende Vorrichtung nach einem der Ansprüche 1 bis 4, bei welcher das besagte Polstück scheibenartig ausgebildet ist.

6. Eine ein Magnetfeld erzeugende Vorrichtung nach einem der Ansprüche 1 bis 4, bei welcher das besagte Polstück scheibenartig ausgebildet ist und bei welcher der Randbereich einer Oberfläche des besagten Polstücks, die dem besagten Spalt zugewandt ist, mit einem ringförmigen Vorsprung versehen ist.

7. Eine ein Magnetfeld erzeugende Vorrichtung nach einem der Ansprüche 1 bis 4, bei welcher das besagte Polstück scheibenartig ausgebildet ist und bei welcher der Randbereich einer Oberfläche des besagten Polstücks, die dem besagten Spalt zugewandt ist, mit einem ringförmigen Vorsprung und ihr zentraler Teil mit einem konvexen Vorsprung versehen sind.

8. Eine ein Magnetfeld erzeugende Vorrichtung nach einem der Ansprüche 1 bis 4, bei welcher jedes der besagten Polstücke eine im Querschnitt trapezförmige Gestalt aufweist, wobei seine dem besagten Spalt zugewandte Oberfläche kleiner ist als eine Oberfläche an seiner gegenüberliegenden Seite, die an einer Permanentmagnet-Komponente der Vorrichtung anliegt.

9. Eine ein Magnetfeld erzeugende Vorrichtung nach einem der Ansprüche 1 bis 7, bei welcher der magnetische Teil der besagten Schichtung aus einem oder mehreren Teilen eines schraubenförmig gewundenen magnetischen Streifenmaterials gebildet ist.

10. Eine ein Magnetfeld erzeugende Vorrichtung nach einem der Ansprüche 1 bis 7, bei welcher der magnetische Teil der besagten Schichtung aus Siliziumstahl besteht.

11. Eine ein Magnetfeld erzeugende Vorrichtung nach einem der Ansprüche 1 bis 10, bei welcher jedes der das besagte Paar bildenden Polstücke (60) jeweils an einer Permanentmagnet-Komponente (63) eines Paares von einander gegenüberliegenden Permanentmagnet-Komponenten befestigt ist, und Jochmittel (64) zur magnetischen Koppelung des besagten Komponentenpaares vorhanden sind und bei welcher jede der besagten Permanentmagnet-Komponenten (63) ein ringförmiger Körper ist mit einem Durchgangsloch (61a) in seinem Zentrum, welches sich zu dem an dieser Komponente (63) befestigten Polstück (60) hin erstreckt und in das ein Pfropfen (62) aus magnetischem Material eingesetzt und in besagtem Loch (61a) justierbar ist, um eine Feinjustierung der magnetischen Feldstärke im Spalt (65) zu erzielen, welcher zwischen den einander gegenüberliegenden Polstücken (60) der das magnetische Feld erzeugenden Vorrichtung angeordnet ist.

## Revendications

1. Dispositif engendrant un champ magnétique comportant une paire d'aimants permanents (1) disposés l'un en face de l'autre en formant un entrefer entre eux, une culasse (3) pour le couplage magnétique de la paire d'aimants permanents, et des pièces polaires (10) qui sont fixées par une face d'extrémité à une face de l'aimant permanent associé, dont la face d'extrémité opposée fait face à l'entrefer, le dispositif engendrant un champ magnétique étant agencé pour engendrer un champ magnétique dans cet entrefer, caractérisé en ce que chaque pièce polaire (10) est composée d'une partie pleine formant noyau (10b), qui a une surface latérale extérieure, et d'une partie extérieure formée d'un stratifié (10a) de feuillets magnétiques et de feuillets non magnétiques mis en position autour de la partie pleine formant noyau, les feuillets stratifiés (10a) étant sensiblement parallèles à la surface latérale extérieure de la partie pleine formant noyau (10b) de chaque pièce polaire magnétique (10) ;
et en ce que, pour chaque pièce polaire (10), le rapport du diamètre extérieur D_{B} de la partie pleine non stratifiée (10b) au diamètre extérieur D_{P} de la pièce polaire (10), D_{B}:D_{P}, est compris entre 0,2:1 et 0,95:1.

2. Dispositif engendrant un champ magnétique selon la revendication 1, caractérisé, en outre, en ce que,
chaque pièce polaire (10) comprend une partie pleine formant noyau (10b) en un matériau magnétique ayant une surface latérale extérieure qui est un solide de révolution autour de l'axe du champ magnétique qui traverse l'entrefer (4) entre les pôles opposés, la partie pleine formant noyau étant entourée d'un stratifié (10a) formé de plusieurs couches, les couches étant disposées, l'une entourant l'autre, autour de la surface latérale extérieure de la partie pleine et non stratifiée formant noyau (10b), les couches successives (10c, 10d) du stratifié étant alternativement en un matériau magnétique et en un matériau ayant une grande réluctance magnétique.

3. Dispositif engendrant un champ magnétique selon la revendication 2, dans lequel les couches qui sont en un matériau magnétique sont fixées à des plis ou à des couches intermédiaires qui sont en un matériau non magnétique.

4. Dispositif engendrant un champ magnétique selon la revendication 3, dans lequel les plis ou les couches intermédiaires sont en une résine ou en papier.

5. Dispositif engendrant un champ magnétique selon l'une quelconque des revendications 1 à 4, dans lequel la pièce polaire a une forme analogue à celle d'un disque.

6. Dispositif engendrant un champ magnétique selon l'une quelconque des revendications 1 à 4, dans lequel la pièce polaire a une forme analogue à celle d'un disque et dans lequel la partie périphérique d'une face de la pièce polaire qui fait face à l'entrefer est munie d'une saillie annulaire.

7. Dispositif engendrant un champ magnétique selon l'une quelconque des revendications 1 à 4, dans lequel la pièce polaire a une forme analogue à celle d'un disque et dans lequel la partie périphérique de la face de la pièce polaire qui fait face à l'entrefer est munie d'une saillie annulaire et la partie centrale de celle-ci est munie d'une saillie convexe.

8. Dispositif engendrant un champ magnétique selon l'une quelconque des revendications 1 à 4, dans lequel la section transversale de chaque pièce polaire est trapézoïdale, sa face faisant face à l'entrefer étant plus petite qu'une face de son côté opposé qui vient en butée sur l'aimant permanent du dispositif.

9. Dispositif engendrant un champ magnétique selon l'une quelconque des revendications 1 à 7, dans lequel la partie magnétique du stratifié est formée d'une ou de plusieurs parties en feuillard magnétique enroulé en hélice.

10. Dispositif engendrant un champ magnétique selon l'une quelconque des revendications 1 à 7, dans lequel la partie magnétique du stratifié est formée d'un feuillet d'acier au silicium.

11. Dispositif engendrant un champ magnétique selon l'une quelconque des revendications 1 à 10, dans lequel chacune des paires de pièces polaires (60) est fixée à l'un (63) respectivement des aimants permanents des paires opposées,
une culasse (64) couplant magnétiquement la paire d'aimants,
et dans lequel chacun des aimants permanents (63) est un corps annulaire ayant un trou traversant (61a) en son centre et s'étendant vers la pièce polaire (60) fixée à cet aimant (63) et comprenant un tampon (62) en un matériau magnétique inséré, et réglable dans le trou (61a), pour obtenir un réglage fin de l'intensité du champ magnétique dans l'entrefer (65) qui est formé entre les pièces polaires opposées (60) du dispositif générant un champ magnétique.
